# EUROPÄISCHE PATENTSCHRIFT

(11) **EP 1 601 239 B1**
(45) Veröffentlichungstag und Bekanntmachung des Hinweises auf die Patenterteilung: **13.06.2007**
(21) Anmeldenummer: 05103281.1
(22) Anmeldetag: 22.04.2005
(51) Int. Cl.: H05K 7/10, H05K 7/14

(54) **Kühlanordnung für ein elektrisches oder elektronisches Bauteil und Verfahren zu deren Montage**
Cooling device for an electric or electronic component and method for mounting the same
Dispositif de refroidissement pour un composant électrique ou électronique ainsi que la maniére de le monter

(30) Priorität: 25.05.2004 DE 102004025523
(43) Veröffentlichungstag der Anmeldung: 30.11.2005
(73) Patentinhaber: ebm-papst Mulfingen GmbH & Co.KG, 74673 Mulfingen (DE)
(72) Erfinder: KILIAN, Thomas, 74214, Schöntal-Westernhausen (DE); SCHMITT, Martin, Dipl.-Ing. (FH), 97922 Lauda-Königshofen (DE); HOFMANN, Walter, 74673, Mulfingen (DE); SCHWARZ, Jochen, 74214, Schöntal-Berlichingen (DE)
(74) Vertreter: Patentanwälte Dr. Solf & Zapf

(56) Entgegenhaltungen:
- DE-A1- 4 409 015
- GB-A- 1 207 265
- US-A- 5 309 979
- US-A- 5 936 839

## Beschreibung

Die Erfindung betrifft eine Kühlanordnung für ein elektrisches oder elektronisches Bauteil, umfassend das zu kühlende Bauteil und einen Kühlkörper zur Aufnahme der von dem zu kühlenden Bauteil abzuführenden Wärme. Des Weiteren betrifft die Erfindung ein Verfahren zur Montage einer solchen Kühlanordnung.

Leistungskomponenten in elektrischen Schaltkreisen, wie beispielsweise Platinen in Personalcomputern oder Laptops entwickeln oft erhebliche Wärmemengen, die durch das Herstellen eines thermischen Kontaktes zwischen der jeweiligen Leistungskomponente als einem zu kühlenden Bauteil und einem Kühlkörper, beispielsweise einem aus Aluminium bestehenden Gehäuse, als Verlustleistung abgeführt werden müssen. Hierzu sind Kühlanordnungen der eingangs genannten Art bekannt.

Die bekannten Kühlanordnungen weisen den Nachteil auf, dass bei und auch nach der Montage auf das zu kühlende Bauteil Biege-, Druck-, und/oder Zugbelastungen ausgeübt werden, die - wenn sie auf Lötstellen des Bauteils an einer elektrischen Leiterplatte wirken, zu Beschädigungen führen können. Dies kann beispielsweise langfristig eine Entmischung der Lote und somit die Ausbildung von sogenannten "kalten" Lötstellen sein. Bei den verschiedenen bekannten technischen Lösungen für Kühlanordnungen wird außerdem eine erforderliche Anpresskraft von zu kühlendem Bauteil an den Kühlkörper unter Zuhilfenahme von zusätzlichen Bauteilen wie Schrauben, Klammern, Bügeln, Federn oder ähnlichem aufgebracht, was mit hohen Montagezeiten und erheblichem Montageaufwand verbunden ist.

Der Erfindung liegt die Aufgabe zugrunde, mit geringem fertigungstechnischen Aufwand eine Kühlanordnung der eingangs beschriebenen Art zu schaffen, die es gestattet, einen thermischen Kontakt zwischen dem, insbesondere auf einer Platine angeordneten, zu kühlenden Bauteil und dem Kühlkörper, wie einem die Kühlanordnung und die Platine umgebenden, vorzugsweise metallischen Gehäuse herzustellen, wobei die Verlustleistung durch die beidseitige, eine vergrößerte Anlagefläche bildende Anbindung des zu kühlenden elektrischen oder elektronischen Bauteils sicher abgeführt werden soll und keine Kräfte in gegebenenfalls vorhandene Lötstellen des Bauteils und darüber hinaus auch keine Spannungen in die Leiterplatten eingeleitet werden.

Diese Aufgabe wird in Bezug auf die Kühlanordnung erfindungsgemäß dadurch gelöst, dass das zu kühlende Bauteil unter Zwischenlage eines folien-, matten-, filmschicht- oder bandartigen Wärmeleitelements formschlüssig in eine Aufnahmeöffnung des Kühlkörpers eingreift.

In Bezug auf das Montageverfahren wird diese Aufgabe dadurch gelöst, dass zunächst eine Aufnahmeöffnung des Kühlkörpers für das zu kühlende Bauteil mit einem folien-, matten-, filmschicht- oder bandartigen Wärmeleitelement bedeckt und danach das Wärmeleitelement unter Deformation durch das zu kühlende Bauteil und unter Ausbildung einer formschlüssigen Verbindung mit dem Kühlkörper in die Aufnahmeöffnung eingedrückt wird.

Hierbei ist es im Sinne einer sicheren und genauen Montage besonders vorteilhaft, wenn bei der Bedeckung der Aufnahmeöffnung über vom Kühlkörper vorstehende Stifte oder einen die Aufnahmeöffnung umgebenden, zur Auflage des Wärmeleitelements bestimmten Rand das Wärmeleitelement positioniert und/oder vorfixiert wird.

Durch die Erfindung wird einerseits mit Vorteil im Hinblick auf eine langzeitlich stabile Funktionserfüllung der Kühlanordnung erreicht, dass Lötstellen am zu kühlenden Bauteil bei der Montage nur kurzzeitig und im montiertem Zustand überhaupt nicht belastet werden. Andererseits besteht im Hinblick auf die Ökonomie der Verfahrensführung ein erheblicher Vorteil darin, dass für die Montage außer dem in geeigneter Weise als Folie, Matte, Filmschicht oder Band ausgebildeten Wärmeleitelement keine weiteren Bauteile - auch nicht notwendigerweise zur elektrischen Isolation - benötigt werden.

Weitere vorteilhafte Ausführungen der Erfindung sind in den Unteransprüchen und der nachfolgenden Beschreibung enthalten. Anhand zweier in den beiliegenden Zeichnungsfiguren dargestellter Ausführungsbeispiele wird die Erfindung näher erläutert. Es zeigen:
- Fig. 1: eine Schnittdarstellung eines elektrischen bzw. elektronischen Gerätes mit einer erfindungsgemäßen, im Montagezustand befindlichen Kühlanordnung in einer ersten Ausführung,
- Fig. 2: eine in Fig. 1 mit II bezeichnete Einzelheit,
- Fig. 3: eine Fig. 1 entsprechende Schnittdarstellung des Gerätes mit der erfindungsgemäßen Kühlanordnung in der ersten Ausführung, jedoch in einem Verfahrensschritt des erfindungsgemäßen Verfahrens,
- Fig. 4: in Analogie zu Fig. 2, eine in Fig. 3 mit IV bezeichnete Einzelheit,
- Fig. 5: eine perspektivische Darstellung eines Gehäuses des in Fig. 1 bis 4 dargestellten Gerätes,
- Fig. 6: eine perspektivische Darstellung eines Teils eines elektrischen bzw. elektronischen Gerätes mit einer erfindungsgemäßen, im Montagezustand befindlichen Kühlanordnung, in einer zweiten Ausführung.

In den Figuren der Zeichnung sind dieselben Teile auch stets mit denselben Bezugszeichen versehen, so dass sie in der Regel auch jeweils nur einmal beschrieben werden.

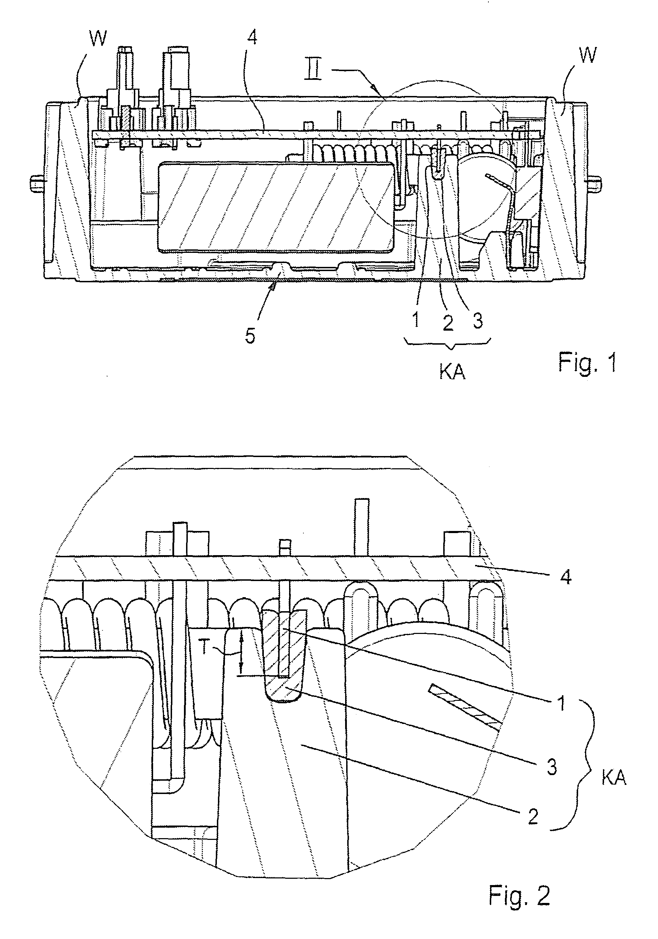

Wie zunächst Fig. 1 und im Detail Fig. 2 zeigen, umfasst eine erfindungsgemäße Kühlanordnung KA für ein elektrisches oder elektronisches Bauteil das zu kühlende Bauteil 1 und einen Kühlkörper 2 zur Aufnahme der von dem zu kühlenden Bauteil 1 abzuführenden Wärme.

Erfindungsgemäß ist vorgesehen, dass das zu kühlende Bauteil 1 unter Zwischenlage eines folien-, matten-, filmschicht- oder bandartigen Wärmeleitelements 3 formschlüssig in eine Aufnahmeöffnung des Kühlkörpers 1 eingreift.

Im Sinne einer hohen Kühlleistung ist dabei ein Wärmeleitelement 3 als besonders effizient zu betrachten, das aus einem Material mit einer Wärmeleitfähigkeit im Bereich von mindestens 0,7 W/m K, vorzugsweise von 0,8 W/m K bis 1,5 W/m K, besteht.

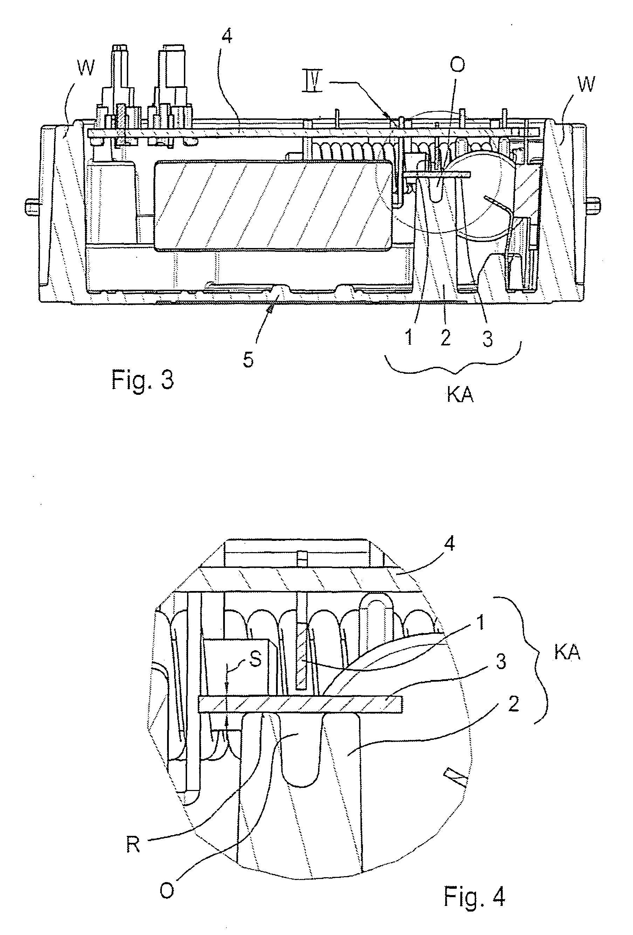

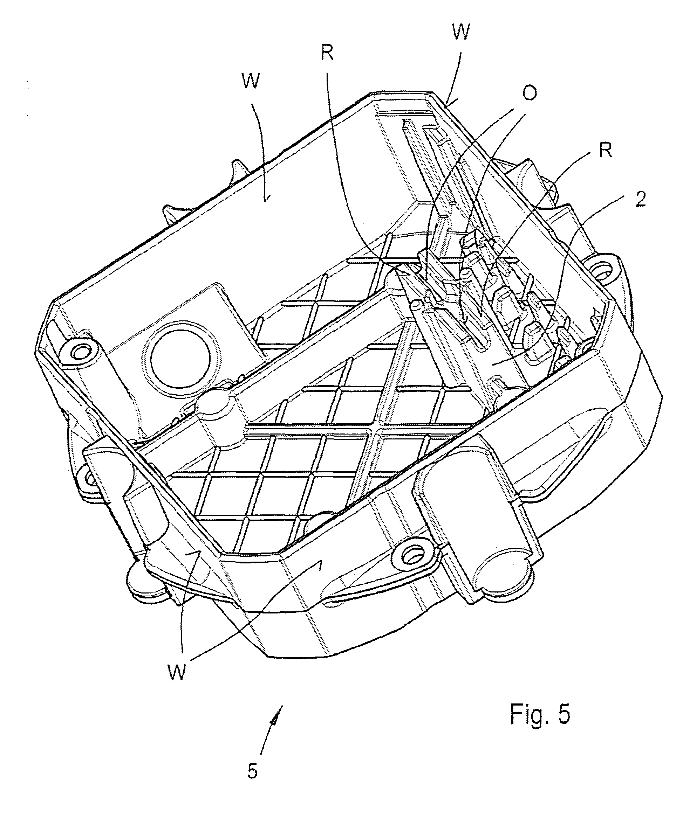

Die Aufnahmeöffnung ist in Fig. 3 und 4 sowie in Fig. 5 mit dem Bezugszeichen O bezeichnet. In Fig. 5 sind das zu kühlende Bauteil 1 und das Wärmeleitelement 3 nicht gezeigt.

Bei dem zu kühlenden Bauteil 1 handelt es sich in den beiden dargestellten Ausführungen jeweils um ein flaches Stanzteil aus Blech, im Folgenden auch Shunt genannt, das auf einer Leiterplatte 4 des elektrischen bzw. elektronischen Gerätes als Messwiderstand eingelötet ist. Am Shunt fällt eine hohe Verlustleistung in Form von Wärme an, die, um eine Überhitzung zu verhindern, abgeführt werden muss. Um die Wärme sicher abführen zu können, ist dabei - wie sich aus den beiden dargestellten Ausführungen ergibt - ein thermischer, elektrisch isolierter Kontakt zu einem, vorzugsweise aus Aluminium bestehenden Gehäuse 5 und somit zur Umgebungsluft als besonders effektiv anzusehen.

Das Gehäuse 5 ist als Einzelteil in Fig. 5 dargestellt. Wie aus der Zeichnung ersichtlich ist, ist der Kühlkörper 2 aus einem insbesondere metallischen, vorzugsweise aus Aluminium bestehenden, Bauteil gebildet, das im Folgenden als Dom bezeichnet wird und einstückig mit dem Gehäuse 5 ausgeführt ist. Alternativ könnte es sich auch um einen mit dem Gehäuse 5 verbindbaren, insbesondere starren Körper handeln.

Insbesondere können ein oder - wie Fig. 5 veranschaulicht - auch mehr Dome vorgesehen sein, die mit einer V- oder U-förmigen Nut als Aufnahmeöffnung O unterhalb der Position des Shunts angeordnet sind.

In montiertem Zustand (Fig. 1, 2) ragt der Shunt bis zu einem vorher für die Wärmeabfuhr errechneten Maß - in Fig. 2 als Eintauchtiefe T bezeichnet - in die Aufnahmeöffnung O des jeweiligen Kühlkörpers 2.

Die jeweiligen Kühlkörper 2 werden dabei durch das Wärmeleitelement 3 gegenüber dem zu kühlenden Bauteil 1 auch elektrisch isoliert. Hierzu ist es zweckmäßig, wenn das Wärmeleitelement 3 aus einem elektrisch isolierenden Material, insbesondere mit einem spezifischen elektrischen Widerstand von mehr als 10¹¹ Ωcm und einer Durchschlagsfestigkeit von mehr als 10 kV/mm, besteht.

Das Wärmeleitelement 3 kann insbesondere aus einem flachen Material mit einer mittleren Stärke s, die in Fig. 4 dargestellt ist, im Bereich von 0,2 mm bis 7,0 mm, insbesondere von 0,5 mm bis 3,0 mm bestehen.

Außerdem ist es von Vorteil, wenn das Wärmeleitelement 3 aus einem, unter bei einer Montage von zu kühlendem Bauteil 1 und Kühlkörper 2 auftretenden Fügekräften zur Herstellung des Formschlusses, plastisch und/oder elastisch verformbaren, insbesondere komprimierbaren, Material besteht.

Solche Materialien, die aus einem, gegebenenfalls faserverstärktem oder einen Füllstoff, wie Aluminiumoxid, enthaltenden, Polymer, wie einem Silikonelastomer oder einem Polyacrylat, gebildet sein können, sind unter den Handelsnamen "Gap-Pad", "Sil-Pad", "Hi-Flow" u.a. bekannt.

So ist beispielsweise unter dem Namen "Gap-Pad" eine hoch anpassungsfähige, weiche Wärmeleitfolie im Handel, die auch komprimierbar ist und dadurch eine Formanpassung an unterschiedliche Bauteilgeometrien und an unebene gegebenenfalls strukturierte, Oberflächen gestattet.

Wie bereits erwähnt, kann das Wärmeleitelement 3 als Folie, Matte, Filmschicht oder Band ausgeführt sein, wobei als dafür geeignete Materialien auch mit einer Selbstklebebeschichtung auf Vliesträgern oder - zur Erzielung einer erhöhten Reißfestigkeit - mit Einlagen aus Glasgewebe ausgerüstete Materialien zur Verwendung in Frage kommen.

In diesem Zusammenhang ist zu erwähnen, dass es unter dem Aspekt der - insbesondere bei der Verarbeitung und Montage auftretenden - möglichen Beanspruchungen zweckmäßig ist, wenn das Wärmeleitelement 3 aus einem Material mit einer Mindestzugfestigkeit von 150 N/cm², vorzugsweise von 300 N/cm², besteht.

Ein erfindungsgemäß für das Wärmeleitelement 3 bevorzugt einsetzbares, hoch wärmeleitfähiges, elektrisches isolierendes Silikonelastomer mit sehr guter elastischer Anpassungsfähigkeit kann insbesondere eine Shore-A-Härte im Bereich von 15 bis 40, vorzugsweise von 15 bis 30, aufweisen. So kann schon bei einem geringen Anpressdruck eine sehr gute Anpassung an unregelmäßige Formen erreicht werden.

Zur erfindungsgemäßen Montage der erfindungsgemäßen Kühlanordnung wird, wie Fig. 3 und 4 veranschaulichen, zunächst die Aufnahmeöffnung O des Kühlkörpers 2 für das zu kühlende Bauteil 1 mit dem Wärmeleitelement 3 bedeckt und danach das Wärmeleitelement 3 unter Deformation durch das zu kühlende Bauteil 1 und unter Ausbildung einer formschlüssigen Verbindung mit dem Kühlkörper 2 in die Aufnahmeöffnung O eingedrückt.

Das zu kühlende Bauteil 1 mit dem zwischengelegten Wärmeleitelement 3 wird dabei bis zu der in Fig. 2 dargestellten Eintauchtiefe T in die Aufnahmeöffnung O des Kühlkörpers 2 eingeführt, die entsprechend der vom kühlenden Bauteil 1 abzuführenden Wärmemenge dimensioniert ist.

Bei der Montage kommt die oben erwähnte, bevorzugte Eigenschaft des Wärmeleitelements 3 zum Tragen, dass dieses aus einem bei den auftretenden Fügekräften zur Herstellung des Formschlusses verformbaren Material besteht.

Bei der Bedeckung der Aufnahmeöffnung O kann in verfahrenstechnisch vorteilhafter Weise - wie Fig. 4 und 5 zeigen - auf einem die Aufnahmeöffnung O des Kühlkörpers 2 umgebenden bzw. begrenzenden, zur Auflage des Wärmeleitelements 3 bestimmten Rand R das Wärmeleitelement 3 positioniert und/oder vorfixiert werden.

Insbesondere bei Vorhandensein eines Randes ist es dabei vorteilhaft, wenn das Wärmeleitelement 3 aus einem, derart formstabilen Material besteht, dass es sich unter seinem Eigengewicht bei Auflage auf den Rand R um die Aufnahmeöffnung O nicht verformt, wie dies Fig. 4 veranschaulicht.

Nach dem Vorfixieren des Wärmeleitelementes 3, insbesondere eines Gap-Pads, auf die Aufnahmeöffnung O wird die Leiterplatte 4, auf der das zu kühlende Bauteil 1 montiert ist, in das Gehäuse 5 eingelegt und mit einer geeigneten Vorrichtung senkrecht bis auf eine Endlage heruntergeführt. Dabei kann vorteilhafterweise eine formschlüssige Führung durch Wände W des Gehäuses 5 erfolgen. Dieser Endlage, deren Einnahme durch Ausnehmungen in der Leiterplatte 4 kontrolliert werden kann, welche als Aufnahmen für Rastelemente des Gehäuses 5 dienen, entspricht die oben erwähnte Eintauchtiefe T des Bauteils 1, beispielsweise des Shunts in die V-Nut.

Beim Absenken der Leiterplatte 4 taucht der Shunt in die Nut ein und drückt bzw. zieht das Gap-Pad nach unten, das sich dabei um den Shunt legt und diesen elektrisch isoliert sowie den thermischen Kontakt zum Kühlkörper 2 und somit zum Gehäuse 5 herstellt. Insbesondere über eine Weichkomponente des Wärmeleitelements 3, wie beispielsweise einen geeigneten Füllstoff eines Gap-Pads, kann dabei mit Vorteil ein Ausgleich von Fertigungstoleranzen erfolgen. Vor allem eine konisch ausgebildete bzw. sich mit Abstand von der Oberfläche verjüngende Aufnahmeöffnung O, wie die dargestellte im Querschnitt V-förmig ausgebildete Nut, begünstigt dabei den Prozess der - zumindest teilweise stattfindenden - Umhüllung des zu kühlenden Bauteils 1 durch das Wärmeleitelement 3.

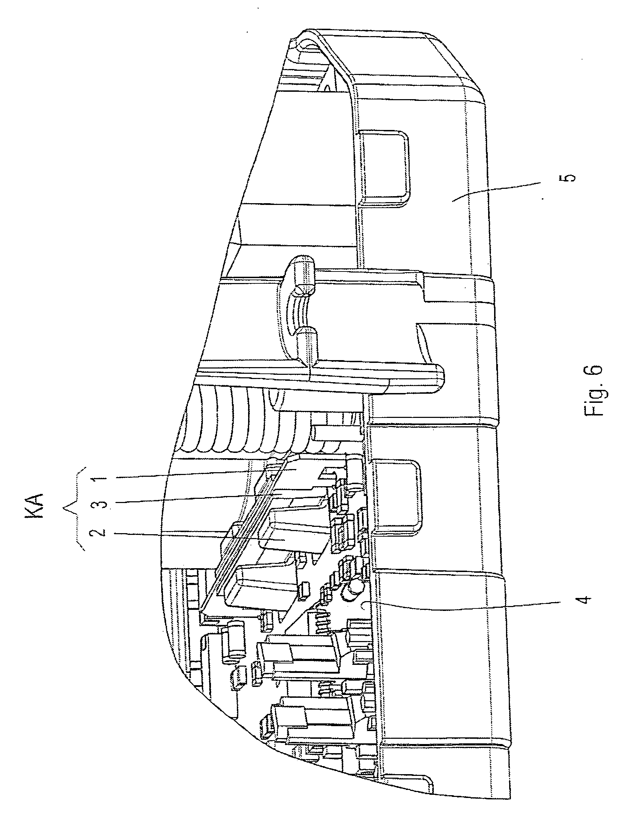

Wie Fig. 6 veranschaulicht, kann das erfindungsgemäße Montageverfahren vorteilhafterweise - nicht nur wie vorstehend beschrieben - zur verdeckten Montage, d. h. beispielsweise bei einem Shunt, der auf der Unterseite der Leiterplatte 4 angeordnet ist, sondern auch zur offenen Montage, d. h. bei einem Shunt oder anderem zu kühlenden Bauteil 1 auf der Oberseite der Leiterplatte 4, Anwendung finden. Bei der in Fig. 6 dargestellten zweiten Ausführung ragen dabei die Dome des Gehäuses 5 als Kühlkörper 2 durch (nicht näher bezeichnete) Öffnungen in der Leiterplatte nach oben.

Wie bereits aus den vorstehenden Ausführungen hervorgeht, ist die vorliegende Erfindung nicht auf die dargestellten Ausführungsbeispiele beschränkt, sondern umfaßt alle im Sinne der Erfindung gleichwirkenden Mittel und Maßnahmen. So könnte beispielsweise die beschriebene Positionierung und/oder Vorfixierung des Wärmeleitelementes 3 auch über vom Kühlkörper 2, wie vom dargestellten Dom des Gehäuses 5, vorstehende Stifte, die in komplementäre Aussparungen oder Bohrungen des Wärmeleitelements 3 eingreifen, erfolgen.

Das zu kühlende Bauteil 1 sollte im Allgemeinen bevorzugt vor der Herstellung der formschlüssigen Verbindung mit dem Kühlkörper 2 auf der elektrischen Leiterplatte 4 montiert, insbesondere mit der Leiterplatte 4 verlötet, werden, es fällt aber auch in den Rahmen der Erfindung, wenn diese Anordnung nach der Herstellung der formschlüssigen Verbindung erfolgt.

Ferner ist die Erfindung nicht auf die in den unabhängigen Ansprüchen 1 und 17 definierten Merkmalskombinationen beschränkt, sondern kann auch durch jede beliebige andere Kombination von bestimmten Merkmalen aller insgesamt offenbarten Einzelmerkmale definiert sein. Dies bedeutet, dass grundsätzlich praktisch jedes Einzelmerkmal der genannten Ansprüche weggelassen bzw. durch mindestens ein an anderer Stelle der Anmeldung offenbartes Einzelmerkmal ersetzt werden kann. Insofern ist die Anspruchsfassung lediglich als ein erster Formulierungsversuch für eine Erfindung zu verstehen.

### Bezugszeichen

- 1: zu kühlendes Bauteil (Shunt)
- 2: Kühlkörper (Dom an 5)
- 3: Wärmeleitelement (Gap-Pad)
- 4: Leiterplatte
- 5: Gehäuse

- KA: Kühlanordnung
- O: Öffnung in 2 (Nut)
- R: Rand von 2
- s: Stärke von 3
- T: Eintauchtiefe von 1 in O
- W: Wand von 5

## Patentansprüche

1. Kühlanordnung für ein elektrisches oder elektronisches Bauteil (1), umfassend das zu kühlende Bauteil (1) und einen Kühlkörper (2) zur Aufnahme der von dem zu kühlenden Bauteil (1) abzuführenden Wärme, wobei das zu kühlende Bauteil (1) unter Zwischenlage eines folien-, matten-, filmschicht- oder bandartigen Wärmeleitelements (3) an dem Kühlkörper (2) befestigt ist,
**dadurch gekennzeichnet, dass** der Kühlkörper (2) eine Aufnahmeöffnung (O), wie eine Nut, aufweist, in die das mit dem Wärmeleitelement (3) bedeckte und außerdem durch das Wärmeleitelement (3) zumindest teilweise umhüllte zu kühlende Bauteil (1) unter Formanpassung des Wärmeleitelements (3) an die Aufnahmeöffnung (O) des Kühlkörpers (2) formschlüssig eingreift.

2. Kühlanordnung nach Anspruch 1,
**dadurch gekennzeichnet, dass** das zu kühlende Bauteil (1) auf einer elektrischen Leiterplatte (4) angeordnet, insbesondere mit der Leiterplatte (4) verlötet, ist.

3. Kühlanordnung nach Anspruch 1 oder 2,
**dadurch gekennzeichnet, dass** das zu kühlende Bauteil (1) ein flaches, plattenartiges Metallteil, insbesondere ein Blechstanzteil, ist.

4. Kühlanordnung nach einem der Ansprüche 1 bis 3,
**dadurch gekennzeichnet, dass** der Kühlkörper (2) aus einem mit einem Gehäuse (5) verbindbaren starren, insbesondere metallischen, vorzugsweise aus Aluminium bestehenden, Bauteil oder einem Teil des insbesondere aus Metall bestehenden Gehäuses (5) gebildet ist.

5. Kühlanordnung nach einem der Ansprüche 1 bis 4,
**dadurch gekennzeichnet, dass** der Kühlkörper (2) zur formschlüssigen Aufnahme des zu kühlenden Bauteils (1) sowie des zwischengelegten Wärmeleitelements (3) als Aufnahmeöffnung (O) eine Nut, insbesondere eine im Querschnitt V- oder U-förmige Nut, aufweist.

6. Kühlanordnung nach einem der Ansprüche 1 bis 5,
**dadurch gekennzeichnet, dass** eine Eintauchtiefe (T) des zu kühlenden Bauteils (1) in die Aufnahmeöffnung (O) des Kühlkörpers (2) entsprechend der vom kühlenden Bauteil (1) abzuführenden Wärmemenge dimensioniert ist.

7. Kühlanordnung nach einem der Ansprüche 1 bis 6,
**dadurch gekennzeichnet, dass** der Kühlkörper (2) zur Positionierung und/oder Vorfixierung des Wärmeleitelements (3) bei der Montage vorstehende Stifte und das Wärmeleitelement (3) Aussparungen oder Bohrungen aufweist, in welche die Stifte eingreifen.

8. Kühlanordnung nach einem der Ansprüche 1 bis 6,
**dadurch gekennzeichnet, dass** der Kühlkörper (2) zur Positionierung und/oder Vorfixierung des Wärmeleitelements (3) bei der Montage einen die Aufnahmeöffnung (O) umgebenden Rand (R) zur Auflage des Wärmeleitelements (3) aufweist.

9. Kühlanordnung nach Anspruch 8,
**dadurch gekennzeichnet, dass** das Wärmeleitelement (3) aus einem derart formstabilen Material besteht, dass es sich unter seinem Eigengewicht bei Auflage auf den Rand (R) um die Aufnahmeöffnung (O) nicht verformt.

10. Kühlanordnung nach einem der Ansprüche 1 bis 9,
**dadurch gekennzeichnet, dass** das Wärmeleitelement (3) aus einem, unter bei einer Montage von zu kühlendem Bauteil (1) und Kühlkörper (2) auftretenden Fügekräften zur Herstellung des Formschlusses, plastisch und/oder elastisch verformbaren, insbesondere komprimierbaren, Material besteht.

11. Kühlanordnung nach einem der Ansprüche 1 bis 10,
**dadurch gekennzeichnet, dass** das Wärmeleitelement (3) aus einem flachen Material mit einer Stärke (s) im Bereich von 0,2 mm bis 7,0 mm, insbesondere von 0,5 mm bis 3,0 mm besteht.

12. Kühlanordnung nach einem der Ansprüche 1 bis 11,
**dadurch gekennzeichnet, dass** das Wärmeleitelement (3) aus einem elektrisch isolierenden Material, insbesondere mit einem spezifischen elektrischen Widerstand von mehr als 10¹¹ Ωcm und einer Durchschlagsfestigkeit von mehr als 10 kV/mm, besteht.

13. Kühlanordnung nach einem der Ansprüche 1 bis 12,
**dadurch gekennzeichnet, dass** das Wärmeleitelement (3) aus einem Material mit einer Wärmeleitfähigkeit im Bereich von mindestens 0,7 W/m K, vorzugsweise von 0,8 W/m K bis 1,5 W/m K, besteht.

14. Kühlanordnung nach einem der Ansprüche 1 bis 13,
**dadurch gekennzeichnet, dass** das Wärmeleitelement (3) aus einem Material mit einer Mindestzugfestigkeit von 150 N/cm², vorzugsweise von 300 N/cm², besteht.

15. Kühlanordnung nach einem der Ansprüche 1 bis 14,
**dadurch gekennzeichnet, dass** das Wärmeleitelement (3) aus einem Material mit einer Shore-A-Härte im Bereich von 15 bis 40, vorzugsweise von 15 bis 30, besteht.

16. Kühlanordnung nach einem der Ansprüche 1 bis 15,
**dadurch gekennzeichnet, dass** das Wärmeleitelement (3) aus einem, gegebenenfalls faserverstärktem oder einen Füllstoff, wie Aluminiumoxid, enthaltenden, Polymer, wie einem Silikonelastomer oder einem Polyacrylat, besteht.

17. Verfahren zur Montage einer Kühlanordnung (KA) für ein elektrisches oder elektronisches Bauteil (1), umfassend das zu kühlende Bauteil (1) und einen Kühlkörper (2) zur Aufnahme der von dem zu kühlenden Bauteil (1) abzuführenden Wärme, wobei das zu kühlende Bauteil (1) unter Zwischenlage eines folien-, matten-, filmschicht- oder bandartigen Wärmeleitelements (3) an dem Kühlkörpers (2) befestigt wird, insbesondere Verfahren zur Montage einer Kühlanordnung (KA) nach einem der Ansprüche 1 bis 16,
**dadurch gekennzeichnet, dass** zunächst eine Aufnahmeöffnung (O) des Kühlkörpers (2) für das zu kühlende Bauteil (1) mit dem Wärmeleitelement (3) bedeckt und danach das Wärmeleitelement (3) unter Deformation durch das zu kühlende Bauteil (1) und unter Formanpassung des Wärmeleitelements (3) an die Aufnahmeöffnung (O) des Kühlkörpers (2) formschlüssig eingedrückt wird, zur Herstellung einer formschlüssigen Verbindung des zu kühlenden Bauteils (1) mit dem Kühlkörper (2).

18. Verfahren nach Anspruch 17,
**dadurch gekennzeichnet, dass** sich das Wärmeleitelement (3) beim Eindrücken des zu kühlenden Bauteils (1) in die Aufnahmeöffnung (O) des Kühlkörpers (2) unter Formanpassung an die Aufnahmeöffnung (O) und an das zu kühlende Bauteil (1) um das zu kühlende Bauteil (1) legt.

19. Verfahren nach Anspruch 17 oder 18,
**dadurch gekennzeichnet, dass** das zu kühlende Bauteil (1) vor oder nach der Herstellung der formschlüssigen Verbindung mit dem Kühlkörper (2) auf einer elektrischen Leiterplatte (4) montiert, insbesondere mit der Leiterplatte (4) verlötet, wird.

20. Verfahren nach einem der Ansprüche 17 bis 19,
**dadurch gekennzeichnet, dass** das zu kühlende Bauteil (1) mit dem Wärmeleitelement (3) bis zu einer Eintauchtiefe (T) in die Aufnahmeöffnung (O) des Kühlkörpers (2) eingeführt wird, die entsprechend der vom kühlenden Bauteil (1) abzuführenden Wärmemenge dimensioniert ist.

21. Verfahren nach einem der Ansprüche 17 bis 20,
**dadurch gekennzeichnet, dass** bei der Bedeckung der Aufnahmeöffnung (O) über vom Kühlkörper (2) vorstehende Stifte oder einen die Aufnahmeöffnung (O) umgebenden, zur Auflage des Wärmeleitelements (3) bestimmten Rand (R) das Wärmeleitelement (3) positioniert und/oder vorfixiert wird.

22. Verfahren nach einem der Ansprüche 17 bis 21,
**dadurch gekennzeichnet, dass** beim Eindrücken des zu kühlenden Bauteils (1) und des Wärmeleitelements (3) in die Aufnahmeöffnung (O) des Kühlkörpers (2) eine Führung mittels einer Leiterplatte (4) erfolgt, auf der das zu kühlende Bauteil (1) montiert ist, wobei die Leiterplatte (4) formschlüssig zwischen Wände (W) eines Gehäuses (5) eingelegt und dann durch senkrechte Bewegung zwischen den Wänden (W) in eine Endlage gebracht wird.

23. Verfahren nach Anspruch 22,
**dadurch gekennzeichnet, dass** die Einnahme der Endlage des Wärmeleitelements (3) insbesondere durch Ausnehmungen in der Leiterplatte (4), welche als Aufnahmen für Rastelemente des Gehäuses (5) dienen, kontrolliert wird.

24. Verfahren nach einem der Ansprüche 17 bis 23,
**gekennzeichnet durch** die Verwendung eines Wärmeleitelementes (3) mit den Merkmalen des kennzeichnenden Teils eines oder mehrerer der Ansprüche 9 bis 16.

## Claims

1. A cooling arrangement for an electrical or electronic component (1), comprising the component (1) to be cooled and a cooling body (2) to absorb the heat to be dissipated from the component (1) to be cooled, the component (1) to be cooled being fixed to the cooling body (2) with the interposition of a film-like, mat-like, film layer-like or strip-like heat conducting element (3),
**characterised in that** the cooling body (2) comprises a receiving opening (0), such as a groove, into which the component (1) to be cooled, covered with the heat conducting element (3) and furthermore at least partially encased by the heat conducting element (3), engages in a positive-locking manner with shape adaptation of the heat conducting element (3) to the receiving opening (0) of the cooling body (2).

2. A cooling arrangement according to Claim 1,
**characterised in that** the component (1) to be cooled is arranged on an electrical printed circuit board (4), particularly soldered to the printed circuit board (4).

3. A cooling arrangement according to Claim 1 or 2,
**characterised in that** the component (1) to be cooled is a flat, plate-like metal part, particularly a stamped sheet metal part.

4. A cooling arrangement according to one of Claims 1 to 3,
**characterised in that** the cooling body (2) is formed from a rigid, particularly metallic component, preferably consisting of aluminium, connectible to a housing (5), or a part of the housing (5) consisting particularly of metal.

5. A cooling arrangement according to one of Claims 1 to 4,
**characterised in that** the cooling body (2) for receiving the component (1) to be cooled as well as the interposed heat conducting element (3) in a positive-locking manner has a groove, particularly a V- or U-shaped groove in cross-section, as receiving opening (O).

6. A cooling arrangement according to one of Claims 1 to 5,
**characterised in that** an immersion depth (T) of the component (1) to be cooled into the receiving opening (0) of the cooling body (2) is dimensioned according to the quantity of heat to be dissipated from the cooling component (1).

7. A cooling arrangement according to one of Claims 1 to 6,
**characterised in that** the cooling body (2) comprises projecting pins for positioning and/or pre-fixing the heat conducting element (3) during assembly, and the heat conducting element (3) comprises recesses or bores into which the pins engage.

8. A cooling arrangement according to one of Claims 1 to 6,
**characterised in that** the cooling body (2) comprises a margin (R) surrounding the receiving opening (0) to support the heat conducting element (3) for positioning and/or pre-fixing the heat conducting element (3) during assembly.

9. A cooling arrangement according to Claim 8,
**characterised in that** the heat conducting element (3) consists of a material which is dimensionally stable in such a way that it does not deform under its own weight when supported on the margin (R) around the receiving opening (0).

10. A cooling arrangement according to one of Claims 1 to 9,
**characterised in that** the heat conducting element (3) consists of a material which is plastically and/or elastically deformable, particularly compressible, under assembling forces occurring during assembly of the component (1) to be cooled and the cooling body (2) for producing the positive fit.

11. A cooling arrangement according to one of Claims 1 to 10,
**characterised in that** the heat conducting element (3) consists of a flat material with a thickness (s) in the region of 0.2 mm to 7.0 mm, particularly 0.5 mm to 3.0 mm.

12. A cooling arrangement according to one of Claims 1 to 11,
**characterised in that** the heat conducting element (3) consists of an electrically insulating material, particularly with a specific electrical resistance of more than 10¹¹ Ωcm and a dielectric strength of more than 10 kV/mm.

13. A cooling arrangement according to one of Claims 1 to 12,
**characterised in that** the heat conducting element (3) consists of a material with a heat conductivity in the region of at least 0.7 W/m K, preferably 0.8 W/m K to 1.5 W/m K.

14. A cooling arrangement according to one of Claims 1 to 13,
**characterised in that** the heat conducting element (3) consists of a material with a minimum tensile strength of 150 N/cm², preferably 300 N/cm².

15. A cooling arrangement according to one of Claims 1 to 14,
**characterised in that** the heat conducting element (3) consists of a material with a Shore A hardness in the region of 15 to 40, preferably 15 to 30.

16. A cooling arrangement according to one of Claims 1 to 15,
**characterised in that** the heat conducting element (3) consists of a polymer, such as a silicone elastomer or a polyacrylate, optionally fibre-reinforced or containing a filler such as aluminium oxide.

17. A method for assembling a cooling arrangement (KA) for an electrical or electronic component, comprising the component (1) to be cooled and a cooling body (2) to absorb the heat to be dissipated from the component (1) to be cooled, the component (1) to be cooled being fixed to the cooling body (2) with the interposition of a film-like, mat-like, film layer-like or strip-like heat conducting element (3), particularly a method for assembling a cooling arrangement (KA) according to one of Claims 1 to 16,
**characterised in that**, first, a receiving opening (0) of the cooling body (2) for the component (1) to be cooled is covered with the heat conducting element (3) and, thereafter, with deformation by means of the component (1) to be cooled and with shape adaptation of the heat conducting element (3) to the receiving opening (0) of the cooling body (2), the heat conducting element (3) is pressed in in a positive-locking manner to create a positive-locking connection of the component (1) to be cooled to the cooling body (2).

18. A method according to Claim 17,
**characterised in that**, when the component (1) to be cooled is pressed into the receiving opening (0) of the cooling body (2), the heat conducting element (3), with shape adaptation to the receiving opening (0) and to the component (1) to be cooled, wraps around the component (1) to be cooled.

19. A method according to Claim 17 or 18,
**characterised in that** the component (1) to be cooled is mounted on an electrical printed circuit board (4), particularly soldered to the printed circuit board (4), before or after the establishing of the positive-locking connection to the cooling body (2).

20. A method according to one of Claims 17 to 19,
**characterised in that** the component (1) to be cooled is introduced with the heat conducting element (3) into the receiving opening (0) of the cooling body (2) to an immersion depth (T) which is dimensioned according to the quantity of heat to be dissipated from the cooling component (1).

21. A method according to one of Claims 17 to 20,
**characterised in that**, with the receiving opening (0) covered via pins projecting from the cooling body (2) or a margin (R) surrounding the receiving opening (0) and intended for supporting the heat conducting element (3), the heat conducting element (3) is positioned and/or pre-fixed.

22. A method according to one of Claims 17 to 21,
**characterised in that**, when the component (1) to be cooled and the heat conducting element (3) are pressed into the receiving opening (0) of the cooling body (2), guiding takes place by means of a printed circuit board (4) on which the component (1) to be cooled is mounted, the printed circuit board (4) being placed in a positive-locking manner between walls (W) of a housing (5) and then being moved by means of a perpendicular movement between the walls (W) into an end position.

23. A method according to Claim 22,
**characterised in that** the adopting of the end position of the heat conducting element (3) is controlled particularly by recesses in the printed circuit board (4) which serve as receptacles for detent elements of the housing (5).

24. A method according to one of Claims 17 to 23,
**characterised by** the use of a heat conducting element (3) comprising the features of the characterising part of one or more of Claims 9 to 16.

## Revendications

1. Dispositif de refroidissement pour un composant (1) électrique ou électronique, comportant le composant (1) à refroidir et un corps de refroidissement (2) destiné à recevoir la chaleur à évacuer hors du composant (1) à refroidir, le composant (1) à refroidir étant fixé contre le corps de refroidissement (2) moyennant la pose intermédiaire d'un élément thermoconducteur (3) en forme de feuille, mat, couche pelliculaire ou bande, **caractérisé en ce que** le corps de refroidissement (2) comporte une ouverture de réception (O), telle qu'une rainure, dans laquelle s'engage par conjugaison de forme le composant (1) à refroidir, recouvert par l'élément thermoconducteur (3) et enveloppé en outre au moins partiellement par l'élément thermoconducteur (3), moyennant un ajustement de forme de l'élément thermoconducteur (3) à l'ouverture de réception (O) du corps de refroidissement (2).

2. Dispositif de refroidissement selon la revendication 1,
**caractérisé en ce que** le composant (1) à refroidir est monté sur une plaquette de circuits imprimés (4) électrique, en particulier brasé avec la plaquette de circuits imprimés (4).

3. Dispositif de refroidissement selon la revendication 1 ou 2,
**caractérisé en ce que** le composant (1) à refroidir est une pièce métallique plate, en forme de platine, en particulier une pièce en tôle découpée.

4. Dispositif de refroidissement selon l'une quelconque des revendications 1 à 3,
**caractérisé en ce que** le corps de refroidissement (2) est formé par une pièce rigide, en particulier métallique, réalisée de préférence en aluminium, apte à être assemblée à un boîtier (5), ou par une partie du boîtier (5) réalisé en particulier en métal.

5. Dispositif de refroidissement selon l'une quelconque des revendications 1 à 4,
**caractérisé en ce que** le corps de refroidissement (2), pour recevoir par conjugaison de forme le composant (1) à refroidir, ainsi que l'élément thermoconducteur (3) intercalé, comporte une ouverture de réception (O) formée par une rainure, en particulier une rainure ayant une section en forme de V ou de U.

6. Dispositif de refroidissement selon l'une quelconque des revendications 1 à 5,
**caractérisé en ce qu'**une profondeur de pénétration (T) du composant (1) à refroidir dans l'ouverture de réception (O) du corps de refroidissement (2) est dimensionnée conformément à la quantité de chaleur à évacuer hors du composant (1) à refroidir.

7. Dispositif de refroidissement selon l'une quelconque des revendications 1 à 6,
**caractérisé en ce que**, pour le positionnement et/ou la fixation préalable de l'élément thermoconducteur (3) lors du montage, le corps de refroidissement (2) comporte des ergots en saillie et l'élément thermoconducteur (3) comporte des évidements ou forures, dans lesquels s'engagent les ergots.

8. Dispositif de refroidissement selon l'une quelconque des revendications 1 à 6,
**caractérisé en ce que**, pour le positionnement et/ou la fixation préalable de l'élément thermoconducteur (3) lors du montage, le corps de refroidissement (2) comporte un bord (R) entourant l'ouverture de réception (O), sur lequel vient en appui l'élément thermoconducteur (3).

9. Dispositif de refroidissement selon la revendication 8,
**caractérisé en ce que** l'élément thermoconducteur (3) est réalisé dans un matériau à forme stable, de telle sorte qu'il ne se déforme pas sous l'effet de son propre poids lorsqu'il prend appui sur le bord (R) autour de l'ouverture de réception (O).

10. Dispositif de refroidissement selon l'une quelconque des revendications 1 à 9,
**caractérisé en ce que** l'élément thermoconducteur (3) est réalisé dans un matériau apte à se déformer plastiquement et/ou élastiquement, en particulier compressible, sous l'effet des forces d'assemblage générées pendant un montage par le composant (1) à refroidir et le corps de refroidissement (2) en vue de la réalisation de l'assemblage par conjugaison de forme.

11. Dispositif de refroidissement selon l'une quelconque des revendications 1 à 10,
**caractérisé en ce que** l'élément thermoconducteur (3) est réalisé dans un matériau plat avec une épaisseur (s) dans une plage de 0,2 mm à 7,0 mm, en particulier de 0,5 mm à 3,0 mm.

12. Dispositif de refroidissement selon l'une quelconque des revendications 1 à 11,
**caractérisé en ce que** l'élément thermoconducteur (3) est réalisé dans un matériau isolant électrique, en particulier avec une résistivité de plus de 10¹¹ Ωcm et une résistance diélectrique de plus de 10 kV/mm.

13. Dispositif de refroidissement selon l'une quelconque des revendications 1 à 12,
**caractérisé en ce que** l'élément thermoconducteur (3) est réalisé dans un matériau avec une conductibilité thermique dans un domaine d'au moins 0,7 W/mK, de préférence de 0,8 W/mK à 1,5 W/mK.

14. Dispositif de refroidissement selon l'une quelconque des revendications 1 à 13,
**caractérisé en ce que** l'élément thermoconducteur (3) est réalisé dans un matériau avec une résistance à la traction minimum de 150N/cm², de préférence de 300 N/cm².

15. Dispositif de refroidissement selon l'une quelconque des revendications 1 à 14,
**caractérisé en ce que** l'élément thermoconducteur (3) est réalisé dans un matériau avec une dureté Shore A dans le domaine de 15 à 40, de préférence de 15 à 30.

16. Dispositif de refroidissement selon l'une quelconque des revendications 1 à 15,
**caractérisé en ce que** l'élément thermoconducteur (3) est réalisé dans un polymère, tel qu'un élastomère de silicone ou un polyacrylate, le cas échéant, renforcé par fibres ou contenant une matière de remplissage, telle que l'oxyde d'aluminium.

17. Procédé de montage d'un dispositif de refroidissement (KA) pour un composant (1) électrique ou électronique, comportant le composant (1) à refroidir et un corps de refroidissement (2) destiné à recevoir la chaleur à évacuer hors du composant (1) à refroidir, le composant (1) à refroidir étant fixé contre le corps de refroidissement (2) moyennant la pose intermédiaire d'un élément thermoconducteur (3) en forme de feuille, mat, couche pelliculaire ou bande, en particulier procédé de montage d'un dispositif de refroidissement (KA) selon l'une quelconque des revendications 1 à 16, **caractérisé en ce que**, tout d'abord, une ouverture de réception (O) dans le corps de refroidissement (2) pour le composant (1) à refroidir est recouverte par un élément thermoconducteur (3) et, ensuite, l'élément thermoconducteur (3), est enfoncé par conjugaison de forme moyennant une déformation par l'intermédiaire du composant (1) à refroidir et moyennant un ajustement de forme de l'élément thermoconducteur (3) à l'ouverture de réception (O) du corps de refroidissement (2), en vue de réaliser un assemblage par conjugaison de forme du composant (1) à refroidir avec le corps de refroidissement (2).

18. Procédé selon la revendication 17,
**caractérisé en ce que**, au moment de l'enfoncement du composant (1) à refroidir dans l'ouverture de réception (O) du corps de refroidissement (2), l'élément thermoconducteur (3) se pose, moyennant un ajustement de forme, autour du composant (1) à refroidir sur l'ouverture de réception (O) et sur le composant (1) à refroidir.

19. Procédé selon la revendication 17 ou 18,
**caractérisé en ce que**, avant ou après la réalisation de l'assemblage par conjugaison de forme avec le corps de refroidissement (2), le composant (1) à refroidir est monté sur une plaquette de circuits imprimés (4) électrique, en particulier est brasé avec la plaquette de circuits imprimés (4).

20. Procédé selon l'une quelconque des revendications 17 à 19,
**caractérisé en ce que** le composant (1) à refroidir est introduit avec l'élément thermoconducteur (3) jusqu'à une profondeur de pénétration (T) dans l'ouverture de réception (O) du corps de refroidissement (2), laquelle est dimensionnée conformément à la quantité de chaleur à évacuer hors du composant (1) à refroidir.

21. Procédé selon l'une quelconque des revendications 17 à 20,
**caractérisé en ce que**, lors du recouvrement de l'ouverture de réception (O), l'élément thermoconducteur (3) est positionné et/ou fixé préalablement par l'intermédiaire d'ergots en saillie sur le corps de refroidissement (2) ou par l'intermédiaire d'un bord (R) entourant l'ouverture de réception (O) et destiné à l'appui de l'élément thermoconducteur (3).

22. Procédé selon l'une quelconque des revendications 17 à 21,
**caractérisé en ce que**, au moment de l'enfoncement du composant (1) à refroidir et de l'élément thermoconducteur (3) dans l'ouverture de réception (O) du corps de refroidissement (2), il est effectué un guidage au moyen d'une plaquette de circuits imprimés (4), sur laquelle est monté le composant (1) à refroidir, la plaquette de circuits imprimés (4) étant insérée par conjugaison de forme entre des parois (W) d'un boîtier (5) et étant amenée ensuite par un mouvement vertical dans une position finale entre les parois (W).

23. Procédé selon la revendication 22,
**caractérisé en ce que** l'obtention de la position finale de l'élément thermoconducteur (3) est contrôlée en particulier par des évidements dans la plaquette de circuits imprimés (4), qui sont destinés à recevoir des éléments de blocage du boîtier (5).

24. Procédé selon l'une quelconque des revendications 17 à 23,
**caractérisé par** l'utilisation d'un élément thermoconducteur (3) avec les caractéristiques de la partie caractérisante d'une ou de plusieurs revendications 9 à 16.
